# EUROPEAN PATENT SPECIFICATION

(11) **EP 1 045 625 B1**
(45) Date of publication and mention of the grant of the patent: **30.07.2008**
(21) Application number: 00660065.4
(22) Date of filing: 04.04.2000
(51) Int. Cl.: H05K 1/02, H01H 85/046

(54) **A foil fuse made on a circuit board**
Folienschmelzsicherung auf einer Leiterplatte
Fusible à feuille sur un panneau à circuit

(30) Priority: 14.04.1999 FI 990819
(43) Date of publication of application: 18.10.2000
(73) Proprietor: Helvar Oy Ab, 00380 Helsinki (FI)
(72) Inventor: Hakonen, Teuvo, 02610 Espoo (FI)
(74) Representative: LEITZINGER OY

(56) References cited:
- DE-A- 3 447 502
- DE-A- 3 723 832
- US-A- 5 097 247
- PATENT ABSTRACTS OF JAPAN vol. 1995, no. 04, 31 May 1995 (1995-05-31) -& JP 07 030213 A (SANYO ELECTRIC CO), 31 January 1995 (1995-01-31)
- PATENT ABSTRACTS OF JAPAN vol. 1995, no. 06, 31 July 1995 (1995-07-31) -& JP 07 085771 A (ROHM CO), 31 March 1995 (1995-03-31)
- PATENT ABSTRACTS OF JAPAN vol. 014, no. 032 (E-876), 22 January 1990 (1990-01-22) -& JP 01 266784 A (SUMITOMO ELECTRIC IND), 24 October 1989 (1989-10-24)
- PATENT ABSTRACTS OF JAPAN vol. 016, no. 073 (E-1169), 21 February 1992 (1992-02-21) & JP 03 263726 A (KARUSONITSUKU KOWA KK), 25 November 1991 (1991-11-25)

## Description

The object of the invention is a foil fuse made on a circuit board, which fuse consists of a narrowed part of a foil conductor on the surface of the circuit board, the circuit board having an elongated gap which is located adjacent to the foil fuse, the gap and the foil fuse being covered by a protective capsule.

Various kinds of fuse solutions are used on circuit boards. A fuse may be a separate component, such as a fusible resistor or a glass tube fuse. The price of this type of fuses is high.

It is for this reason that the type of foil fuses mentioned above, which are made directly onto the circuit board as a thinning of the conductive pattern, are used. Certain problems and limitations are, however, associated with these foil fuses, because in a short circuit situation their operation is not always reliable and safe, but on the contrary, electrical breakdowns occur and, due to the electric arc phenomenon, molten material may be released from the vicinity of the fuse. Depending on the timing of the short circuit with respect to the half cycle of the mains voltage, operation is uncertain and in certain situations the operation of the fuse may destroy insulating materials. Conventional foil fuses, therefore, involve a risk of electrocution and of fire.

To reduce the above discussed disadvantages, DE 37 238 32 A discloses this kind of fuse on a circuit board. A narrowed part of a foil conductor on the surface of the circuit board is made by drilling or punching the gap both through the conductor and the circuit board. This requires a separate working phase after printing the circuits on the circuit board and the value of the foil fuse can not be set during its printing phase. Furthermore, the central or symmetrical location of the gap with respect to the foil conductor, as preferred, limits the width of the gap smaller than the width of the foil conductor.

The aim of the invention is to provide an improved foil fuse by means of which the disadvantages relating to the above-mentioned known foil fuses can be substantially reduced.

This aim is achieved in accordance with the invention in such a way that there are two foil fuses parallel to one another the foil fuses being narrowed parts of two parallel foil conductors, and between the foil fuses there are two elongated gaps, one gap in the immediate vicinity of each foil fuse, each gap being broader than each of the foil conductors.

The circuit board gap adjacent to the foil fuse guides hot gases, and any splashes of molten material produced during the operation of the foil fuse, to the safe side of the circuit board, on which the conventional components mounted in holes are located.

The invention is, therefore, particularly well-suited for use in connection with so-called mixed boards, which have surface mounted devices (smd) on one side and conventional components mounted in holes on the other. There may naturally be surface mounted devices on both sides of the circuit board, provided that they are at a sufficient distance from the gaps, on the opposite side of the circuit board with respect to the foil fuses.

In a preferred embodiment of the invention, the protective capsule is made of elastic material which is spread as elastic mass to cover the foil fuse and the gap. This type of protective capsule is advantageous with a view to manufacturing technique, but also as concerns functional reliability, because the elasticity of the protective capsule allows hot gases to expand before the gases are guided and discharged through the gaps 4.

An embodiment of the invention is illustrated in the following with reference to the appended drawings, in which
- Figure 1: shows, as seen from above and as section A-A, a part of the circuit board with the foil fuse relating to the invention without the protective capsule;
- Figure 2: shows, as seen from above and as section B-B, a part of the circuit board with a foil fuse corresponding to that shown in Figure 1, when covered by a protective capsule according to one embodiment of the invention; and
- Figure 3: shows, as seen from above and as section C-C, a part of the circuit board with a foil fuse corresponding to that shown in Figure 1, when covered by a protective capsule according to another embodiment of the invention.

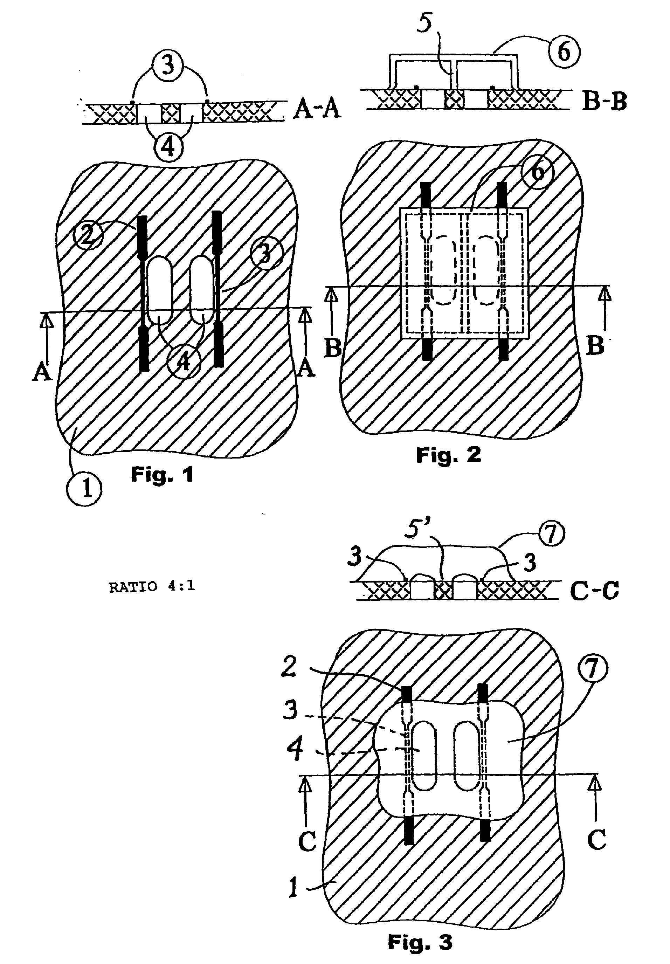

The part of the circuit board 1 depicted in Figures 1 to 3 is shown as seen from the side on which the foil conductors 2 of the circuit board and the solder joints of the components are located. In the case described, a narrowed part 3 acting as a foil fuse has been made on both of the two parallel foil conductors 2. Adjacent to both foil fuses 3, in their immediate vicinity, is an elongated gap 4 in the circuit board 1. In the case shown, the gaps 4 are adjacent to one another, between two foil fuses 3. The gaps may naturally be on either side of the foil fuse, or on both its sides.

In the case of Figure 2, the foil fuses 3 and the gaps 4 are covered by means of a protective capsule 6, which is a separate encapsulating housing fixed on the surface of the circuit board 1 by means of an adhesive or a snap-in type attachment.

The embodiment shown in Figure 3 differs from the former in that the protective capsule 7 is made of elastic material which is spread as elastic mass to cover the foil fuses 3 and the gaps 4. The elastic mass 7 is attached on the surface of the circuit board 1 self-adhesively.

In the case shown, the encapsulating housing 6 or 7 has a separating wall 5 or 5' which is adhered to the circuit board part between the gaps 4. This means that each of the foil fuses 3 operates independently.

Locating the gaps 4 as close to the foil fuse 3 as possible is important, so that explosively expanding gases and possible splashes of molten material will find their way to the gap 4 as easily as possible. The gaps 4 can not be located at the same location (in alignment) with the foil fuse because the foil fuse can be manufactured only onto a solid circuit board.

The invention is applicable to various kinds of circuit board solutions, such as the electronic coupling devices (ballasts) of discharge lamps, light regulators, transformers, and other devices of illumination electronics.

## Claims

1. A circuit board having a foil fuse made or it, which fuse consists of a narrowed part (3) of a foil conductor (2) on the surface of the circuit board (1), the circuit board (1) having an elongated gap (4) which is located adjacent to the foil fuse (3), the gap and the foil fuse being covered by a protective capsule (6, 7),
**characterised in that** there are two foil fuses (3) parallel to one another the foil fuses being narrowed parts of two parallel foil conductors (2), and between the foil fuses there are two elongated gaps (4), one gap in the immediate vicinity of each foil fuse (3), each gap (4) being broader than each of the foil conductors (2).

2. A circuit board as claimed in claim 1, **characterised in that** the encapsulating housing (6, 7) has a separating wall (5, 5') which is adhered to the circuit board part between the adjacent gaps (4).

3. A circuit board as claimed in claim 1 or 2, **characterised in that** the protective capsule (7) is made of elastic material which is spread as elastic mass to cover the foil fuse (3) and the gap (4).

4. A circuit board as claimed in claim 3, **characterised in that** the elastic mass (7) is attached on the surface of the circuit board (1) self-adhesively.

5. A circuit board as claimed in claim 1 or 2, **characterised in that** the protective capsule is a separate encapsulating housing (6) fixed on the surface of the circuit board (1) by means of an adhesive or a snap-in type attachment.

## Patentansprüche

1. Leiterplatte, welche eine auf derselben hergestellte Folienschmelzsicherung aufweist, wobei die Sicherung aus einem verengten Teil (3) eines Folienleiters (2) besteht, an der Fläche der Leiterplatte (1), wobei die Leiterplatte (1) einen langgestreckten Schlitz (4) aufweist, welcher sich benachbart der Folienschmelzsicherung (3) befindet, wobei der Schlitz und die Folienschmelzsicherung von einer Schutzkapsel (6, 7) bedeckt sind,
**dadurch gekennzeichnet, dass** es zwei Folienschmelzsicherungen (3) gibt, welche zueinander parallel sind, wobei die Folienschmelzsicherungen verengte Teile zweier paralleler Folienleiter (2) sind, und dass es zwischen den Folienschmelzsicherungen zwei langgestreckte Schlitze (4) gibt, ein Schlitz in der unmittelbaren Umgebung je einer Folienschmelzsicherung (3), wobei jeder Schlitz (4) breiter ist als jeder der Folienleiter (2).

2. Leiterplatte nach Anspruch 1, **dadurch gekennzeichnet, dass** das Kapselgehäuse (6, 7) eine Trennwand (5, 5') aufweist, welche an den Leiterplattenteil zwischen den benachbarten Schlitzen (4) geklebt ist.

3. Leiterplatte nach Anspruch 1 oder 2, **dadurch gekennzeichnet, dass** die Schutzkapsel (7) aus einem elastischen Material hergestellt ist, welches als elastische Masse aufgetragen ist, zum Bedecken der Folienschmelzsicherung (3) und des Spalts (4).

4. Leiterplatte nach Anspruch 3, **dadurch gekennzeichnet, dass** die elastische Masse (7) selbstklebend an der Fläche der Leiterplatte (1) befestigt ist.

5. Leiterplatte nach Anspruch 1 oder 2, **dadurch gekennzeichnet, dass** die Schutzkapsel ein getrenntes Kapselgehäuse (6) ist, welches an der Fläche der Leiterplatte (1) mittels einer klebenden oder einer einrastenden Art der Befestigung fixiert ist.

## Revendications

1. Carte de circuit sur laquelle est réalisé un fusible en feuille, ce fusible consistant dans une partie rétrécie (3) d'un conducteur en feuille (2), à la surface de la carte de circuit (1), la carte de circuit (1) comportant une fente allongée (4) qui est adjacente au fusible en feuille (3), la fente et le fusible en feuille étant enrobés dans une capsule protectrice (6, 7),
**caractérisée en ce qu'**il est prévu deux fusibles en feuille (3) parallèles entre eux, les fusibles en feuille étant des parties rétrécies de deux conducteurs en feuille (2) parallèles, et deux fentes allongées (4) étant disposées entre les fusibles en feuille, une fente étant située dans le voisinage immédiat de chacun des fusibles en feuille (3), chacune des fentes (4) étant plus large que chacun des conducteurs en feuille (2).

2. Carte de circuit selon la revendication 1, **caractérisée en ce que** le boîtier d'enrobage (6, 7) possède une paroi séparatrice (5, 5') qui est collée à la carte de circuit, notamment entre les fentes adjacentes (4) .

3. Carte de circuit selon l'une des revendications 1 ou 2, **caractérisée en ce que** la capsule protectrice (7) est constituée d'un matériau élastique, qui est réparti comme une masse élastique pour recouvrir le fusible de feuille (3) et la fente (4).

4. Carte de circuit selon la revendication 3, **caractérisée en ce que** la masse élastique (7) est reliée de manière auto-adhésive à la surface de la carte de circuit (1).

5. Carte de circuit selon l'une des revendications 1 ou 2, **caractérisée en ce que** la capsule protectrice est un boîtier séparé (6), qui est relié à la surface de la carte de circuit (1) au moyen d'une liaison adhésive ou à enclenchement.
